(19) Europäisches Patentamt
European Patent Office
Office européen des brevets

(11) EP 4 711 505 A1

(12) EUROPEAN PATENT APPLICATION
published in accordance with Art. 153(4) EPC

(43) Date of publication:
18.03.2026 Bulletin 2026/12

(51) International Patent Classification (IPC):
C25B 11/067 (2021.01)       C25B 11/04 (2021.01)
C25B 11/052 (2021.01)       C25B 11/063 (2021.01)
C25B 11/069 (2021.01)       C25B 11/081 (2021.01)
C25C 7/02 (2006.01)

(21) Application number: 24877150.3

(22) Date of filing: 07.10.2024

(52) Cooperative Patent Classification (CPC):
C25B 11/04; C25B 11/052; C25B 11/063;
C25B 11/067; C25B 11/069; C25B 11/081;
C25C 7/02

(86) International application number:
PCT/JP2024/035789

(87) International publication number:
WO 2025/079555 (17.04.2025 Gazette 2025/16)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 11.10.2023 JP 2023175657

(71) Applicant: Industrie De Nora S.P.A.
20134 Milano (IT)

(72) Inventors:
• ANDO, Tomohiro
  Fujisawa-shi, Kanagawa 252-0816 (JP)
• FURUSAWA, Takashi
  Fujisawa-shi, Kanagawa 252-0816 (JP)
• KATO, Akihiro
  Fujisawa-shi, Kanagawa 252-0816 (JP)

(74) Representative: Reitstötter Kinzebach
Patentanwälte
Sternwartstraße 4
81679 München (DE)

(54) OXYGEN-GENERATING ELECTRODE AND PRODUCTION METHOD FOR SAME

(57) An electrode for oxygen evolution that can be used for electrolysis over a long period of time by efficiently consuming iridium used as an active element is provided. An electrode for oxygen evolution (10) includes a substrate (2) made of titanium or a titanium alloy; a first intermediate layer (4) disposed on the substrate (2) and made of a first mixed metal oxide containing titanium and tantalum; a catalyst layer (6) disposed above the first intermediate layer (4) and made of a second mixed metal oxide containing iridium and tantalum; and a second intermediate layer (5) disposed between the first intermediate layer (4) and the catalyst layer (6), made of a tantalum oxide, and having a tantalum content of 1.2 to 2.5 g/m$^2$.

FIG. 1

**Description**

TECHNICAL FIELD

The present invention relates to an electrode for oxygen evolution and a method for producing the same.

BACKGROUND ART

In an electrowinning process of a nonferrous metal, such as copper, nickel, or zinc, a sulfuric acid or strongly acidic electrolytic solution is generally used. Then, as an anode which is a counter electrode, an electrode for oxygen evolution that causes an oxygen evolution reaction is used. A titanium electrode in which a coating layer containing a mixed metal oxide (MMO) is provided as a catalyst layer on a surface thereof has lower overpotential properties with regard to an oxygen evolution reaction, and therefore has been proposed as an anode for an electrowinning process that substitutes for a lead alloy electrode, which has been used as an electrode for oxygen evolution in the conventional art, and can reduce energy consumption.

The mixed metal oxide for forming the catalyst layer is usually a composite oxide of iridium (Ir) as an active element and a valve metal such as tantalum (Ta), tin (Sn), titanium (Ti), zirconium (Zr), or niobium (Nb) as a binder element. As an electrode using such a composite oxide, a titanium electrode for oxygen evolution provided with a catalyst layer containing $IrO_2$-$Ta_2O_5$ (Non-Patent Literature 1), an electrode for electrolysis provided with a coating layer containing platinum (Pt) and a composite oxide of iridium and tantalum (Patent Literature 1), and the like have been proposed.

In addition, an electrode for electrolysis in which a base layer containing titanium and tantalum and formed by an arc ion plating (AIP) method and a catalyst layer made of a mixed metal oxide containing iridium and tantalum are provided on a titanium electrode substrate (Patent Literature 2) has been proposed.

CITATION LIST

PATENT LITERATURE

Patent Literature 1: JPH05-59580A
Patent Literature 2: JP2009-263770A

NON-PATENT LITERATURE

Non Patent Literature 1: Journal of Applied Electrochemistry, 1991, 21, pages 335 to 345

SUMMARY OF INVENTION

TECHNICAL PROBLEM

A catalyst layer made of a mixed metal oxide is gradually consumed by repeated electrolysis. In particular, iridium, which is used as an active element, is one of the most expensive and rare elements, and thus, regarding an electrode for electrolysis having a catalyst layer using iridium, there has been a strong demand for extending a service life in particular by efficiently consuming iridium.

However, even in the electrodes for electrolysis proposed in Patent Literatures 1 and 2, Non-Patent Literature 1, and the like, the service life of the catalyst layer using iridium is not necessarily sufficient, and there is room for further improvement.

The present invention has been devised in view of such problems in the conventional art, and its object is to provide an electrode for oxygen evolution that can be used for electrolysis over a long period of time by efficiently consuming iridium used as an active element. Another object of the present invention is to provide a method for producing an electrode for oxygen evolution that can be used for electrolysis over a long period of time by efficiently consuming iridium used as an active element.

SOLUTION TO PROBLEM

That is, according to the present invention, an electrode for oxygen evolution shown below is provided.

[1] An electrode for oxygen evolution including:

a substrate made of titanium or a titanium alloy;

a first intermediate layer disposed on the substrate and made of a first mixed metal oxide containing titanium and tantalum;

a catalyst layer disposed above the first intermediate layer and made of a second mixed metal oxide containing iridium and tantalum; and

a second intermediate layer disposed between the first intermediate layer and the catalyst layer, made of a tantalum oxide, and having a tantalum content of 1.2 to 2.5 $g/m^2$.

[2] The electrode for oxygen evolution according to [1], further including:
a coating layer disposed on the catalyst layer and containing platinum.

[3] The electrode for oxygen evolution according to [2], in which
a platinum content in the coating layer is 0.5 to 3.0 $g/m^2$.

[4] The electrode for oxygen evolution according to any one of [1] to [3], in which the first intermediate layer is a layer formed by an arc ion plating method.

In addition, according to the present invention, a method for producing an electrode for oxygen evolution shown below is provided.

[5] A method for producing an electrode for oxygen evolution, the method including:

disposing a first intermediate layer made of a first mixed metal oxide containing titanium and tantalum on a substrate made of titanium or a titanium alloy by arc ion plating;

disposing a second intermediate layer made of a tantalum oxide and having a tantalum content of 1.2 to 2.5 $g/m^2$ by coating the first intermediate layer with a coating solution containing tantalum but not containing iridium, and then performing a heat treatment; and

disposing a catalyst layer made of a second mixed metal oxide containing iridium and tantalum by coating the second intermediate layer with a catalyst precursor solution containing iridium and tantalum, and then performing a heat treatment.

[6] The method for producing an electrode for oxygen evolution according to [5], the method further including:
disposing a coating layer containing platinum on the catalyst layer by coating the catalyst layer with a coating solution containing platinum, and then performing a heat treatment.

ADVANTAGEOUS EFFECTS OF INVENTION

According to the present invention, an electrode for oxygen evolution that can be used for electrolysis over a long period of time by efficiently consuming iridium used as an active element can be provided. According to the present invention, a method for producing an electrode for oxygen evolution that can be used for electrolysis over a long period of time by efficiently consuming iridium used as an active element.

BRIEF DESCRIPTION OF DRAWINGS

FIG. 1 is a schematic view showing an embodiment of an electrode for oxygen evolution of the present invention.
FIG. 2 is a schematic view showing another embodiment of the electrode for oxygen evolution of the present invention.
FIG. 3 is a schematic view showing an example of an electrode for oxygen evolution in the conventional art.
FIG. 4 is a schematic view showing an example of an electrode for oxygen evolution used to verify a Pt amount of a coating layer.
FIG. 5 is a graph plotting a predicted value of electrode life (h) with respect to a Ta amount ($g/m^2$) of a second intermediate layer.
FIG. 6 is a graph plotting an initial Ir reduction amount ($g/m^2$) with respect to a Pt amount ($g/m^2$) of the coating layer.

DESCRIPTION OF EMBODIMENTS

<Electrode for Oxygen Evolution>

Hereinafter, an embodiment of the present invention will be described, but the present invention is not limited to the following embodiment. An embodiment of an electrode for oxygen evolution of the present invention includes a substrate made of titanium or a titanium alloy, a first intermediate layer disposed on the substrate and made of a first mixed metal oxide containing titanium and tantalum, and a catalyst layer disposed on the first intermediate layer and made of a second mixed metal oxide containing iridium and tantalum. The electrode for oxygen evolution of the present embodiment further includes a second intermediate layer disposed between the first intermediate layer and the catalyst layer, made of a tantalum oxide, and having a tantalum content of 1.2 to 2.5 $g/m^2$. The electrode for oxygen evolution of the present invention is described in detail below.

(Substrate)

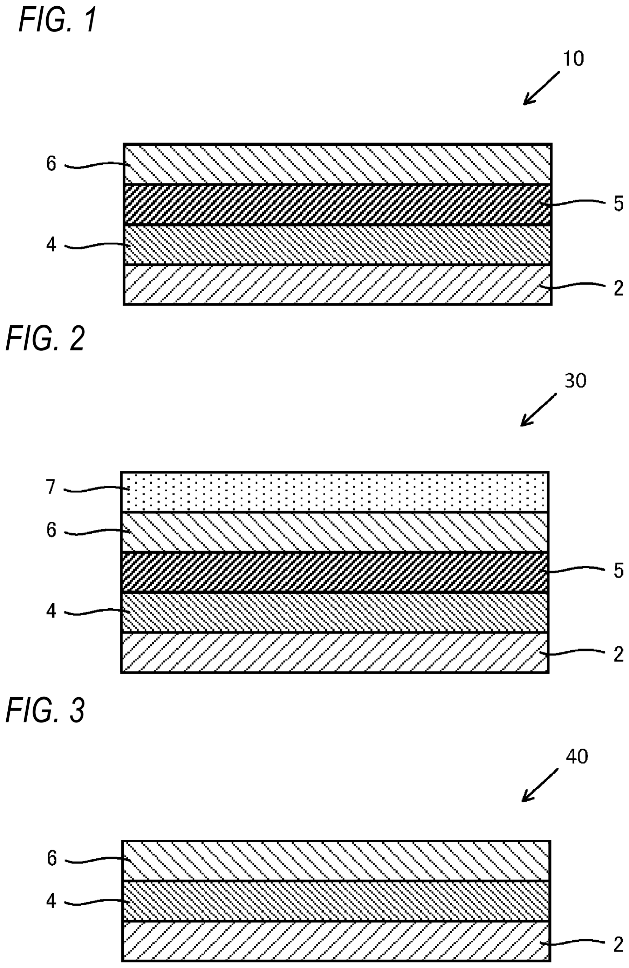

FIG. 1 is a schematic view showing an embodiment of the electrode for oxygen evolution of the present invention. An electrode for oxygen evolution 10 of the present embodiment shown in FIG. 1 includes a substrate 2, a first intermediate layer 4 disposed on the substrate 2, and a catalyst layer 6 disposed above the first intermediate layer 4. The substrate 2 is made of titanium or a titanium alloy. An overall shape of the substrate 2 is not limited, and can be appropriately designed according to an application. Examples of the overall shape of the substrate include a plate shape, a rod (column) shape, and a mesh shape.

(First Intermediate Layer)

The first intermediate layer 4 disposed on the substrate 2 is made of a first mixed metal oxide (FIG. 1). By providing such a first intermediate layer between the substrate and the catalyst layer, passivation of the titanium or titanium alloy substrate due to electrolysis can be prevented, and the substrate can be protected from corrosion. Accordingly, durability can be improved, and an electrode for oxygen evolution capable of electrolysis for a longer period of time can be made.

The first mixed metal oxide forming the first intermediate layer 4 is a mixed oxide of metals including titanium (Ti) and tantalum (Ta). Preferably, the metal elements constituting the first mixed metal oxide are substantially titanium and tantalum only. A thickness of the first intermediate layer is not particularly limited and can be freely set. The thickness of the first intermediate layer may be, for example, 0.2 to 5 $\mu$m.

The first intermediate layer 4 can be formed, for example, by coating a surface of the substrate with a coating solution containing titanium, tantalum, and salts thereof in a desired ratio to form a coated layer, and then baking the coated layer under an appropriate temperature condition (so-called pyrolysis). The desired first intermediate layer can be formed on the substrate by an arc ion plating (AIP) method, a sputtering method, a plasma spraying method, or other methods. In particular, the first intermediate layer is preferably a layer formed by the arc ion plating (AIP) method. It is considered that the first intermediate layer formed by the AIP method has a smaller proportion of voids formed therein and is more likely to have a dense structure than those of the first intermediate layer 4 formed by other methods. Therefore, by including the first intermediate layer formed by the AIP method, an electrode for oxygen evolution with further improved electrode performance can be made. Note that it is substantially difficult to specify a microstructure (shape, size, proportion, and distribution of voids) of the first intermediate layer formed by the AIP method.

(Second Intermediate Layer)

The electrode for oxygen evolution 10 of the present embodiment further includes a second intermediate layer 5 (FIG. 1) which is disposed between the first intermediate layer 4 and the catalyst layer 6 and is made of a tantalum oxide. In an electrode in the conventional art in which a catalyst layer made of a mixed metal oxide containing iridium and tantalum is disposed directly on a substrate or a base layer made of a mixed metal oxide containing titanium and tantalum, iridium tends to segregate toward the substrate, and tantalum tends to segregate toward a surface of the electrode within the catalyst layer. That is, iridium, which is an active element, is distributed closer to the substrate in the catalyst layer, whereas tantalum is distributed closer to the surface of the electrode.

To the contrary, when the second intermediate layer 5 made of the tantalum oxide is disposed between the first intermediate layer 4 and the catalyst layer 6, the segregation of iridium toward the substrate in the catalyst layer 6 is prevented, and the segregation of tantalum toward the surface of the electrode is also prevented. Consumption of iridium in the catalyst layer tends to proceed from the surface of the electrode. Therefore, when focusing on a remaining iridium amount in the catalyst layer 6 under conditions where the electrode degrades (for example, in a case where the catalyst activity gradually decreases and an electrode potential exceeds a desired value), it is expected that an electrode having the second intermediate layer 5 in which the segregation of iridium toward the substrate is prevented has a lower remaining iridium amount than that of the electrode in the conventional art in which iridium is segregated toward the substrate. In other words, the electrode having the second intermediate layer 5 consumes more iridium before the electrode degrades than that of the electrode in the conventional art, and thus iridium is consumed more efficiently. Therefore, when a life of the electrode having the second intermediate layer 5 is predicted, a threshold for the remaining iridium amount at the time of electrode degradation can be set lower than that in the electrode in the conventional art. Accordingly, an electrode for oxygen evolution with a longer life that can be used for electrolysis over a long period of time can be made.

A tantalum content in the second intermediate layer 5 is 1.2 to 2.5 $g/m^2$. The tantalum content in the second intermediate layer 5 is preferably 1.2 to 2.3 $g/m^2$, more preferably 1.5 to 2.3 $g/m^2$ or more, even more preferably 1.5 to 2.0 $g/m^2$, and particularly preferably 1.6 to 2.0 $g/m^2$. If the tantalum content in the second intermediate layer is less than 1.2 $g/m^2$, it becomes difficult to sufficiently extend the life of the electrode for oxygen evolution. On the other hand, if the tantalum content in the second intermediate layer exceeds 2.5 $g/m^2$, the life of the electrode for oxygen evolution may actually be shortened.

(Catalyst Layer)

The catalyst layer 6 is made of a second mixed metal oxide containing iridium and tantalum (FIG. 1). That is, the catalyst layer is made of the second mixed metal oxide, which is a composite oxide containing iridium as an active element and tantalum which is a polyvalent metal element. Preferably, the metal elements constituting the second mixed metal oxide are substantially iridium and tantalum only. The coexistence of tantalum, which is a polyvalent metal element, in the catalyst layer improves conductivity, and an electrode for oxygen evolution with a lower electrode potential can be made. Furthermore, by using tantalum, iridium, which is an active element, becomes difficult to consume even during electrolysis under acidic conditions such as sulfuric acid, and a catalyst layer with long life and excellent durability can be made.

An iridium content in the catalyst layer is preferably 3.0 to 30 $g/m^2$, and more preferably 5 to 20 $g/m^2$. By maintaining the iridium content in the catalyst layer within the above range, higher catalyst activity can be achieved. The iridium content in the catalyst layer is preferably 50 to 80 mass% based on all metal elements in the catalyst layer. By maintaining the iridium content in the catalyst layer within the above range, higher catalyst activity can be achieved. Types and contents of metal elements in each of the layers including the catalyst layer can be measured and calculated by an analysis method such as a fluorescent X-ray (XRF) analysis.

(Coating Layer)

FIG. 2 is a schematic view showing another embodiment of the electrode for oxygen evolution of the present invention. An electrode for oxygen evolution 30 of the present embodiment shown in FIG. 2 includes the substrate 2, the first intermediate layer 4 disposed on the substrate 2, and the catalyst layer 6 disposed above the first intermediate layer 4. The electrode for oxygen evolution 30 of the present embodiment further includes the second intermediate layer 5 disposed between the first intermediate layer 4 and the catalyst layer 6 and made of a tantalum oxide, and a coating layer 7 disposed on the catalyst layer 6 and containing platinum (Pt). Preferably, the metal element in the coating layer is substantially platinum alone. By providing such a coating layer on the catalyst layer, it is possible to reduce the consumption of iridium in the catalyst layer during an initial stage of electrolysis, and an electrode for oxygen evolution that can be used for electrolysis over a long period of time and has a longer life can be made.

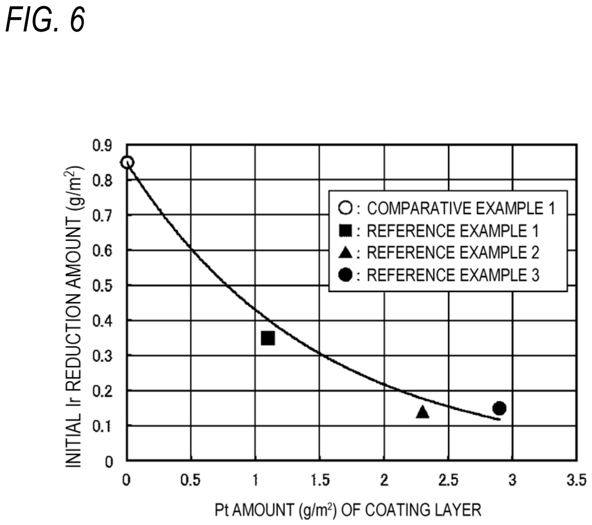

A platinum content in the coating layer is preferably 0.5 to 3.0 $g/m^2$. The platinum content in the coating layer is more preferably 2.0 to 3.0 $g/m^2$, and particularly preferably 2.3 to 2.9 $g/m^2$. If the platinum content is less than 0.5 $g/m^2$, it may be difficult to sufficiently extend the life of the electrode for oxygen evolution. On the other hand, if the platinum content exceeds 3.0 $g/m^2$, an effect obtained by providing the coating layer tends to plateau, and there is a tendency to be disadvantageous in terms of cost (see FIG. 6). A thickness of the coating layer is not particularly limited and can be freely set. The thickness of the coating layer may be, for example, 0.5 to 5 $\mu$m.

(Uses of electrode for oxygen evolution)

The electrode for oxygen evolution of the present embodiment has high conductivity, iridium in the catalyst layer is difficult to consume even when electrolyzing an acidic electrolytic solution such as sulfuric acid, and the electrode for oxygen evolution has durability suitable for long-term electrolysis. Therefore, the electrode for oxygen evolution of the present embodiment is useful, for example, as an anode for an electrowinning process (anode for electrowinning) of non-ferrous metals such as copper (Cu) when used in combination with a cathode for electrowinning of non-ferrous metals such as copper. Furthermore, it is useful as an electrode for oxygen evolution used in an electrolysis process in which an applied current density is 10 $kA/m^2$ or less.

<Method for Producing Electrode for Oxygen Evolution>

An embodiment of a method for producing an electrode for oxygen evolution of the present invention is a suitable method for producing the electrode for oxygen evolution described above. That is, the method for producing an electrode for oxygen evolution of the present embodiment includes a step of disposing a first intermediate layer made of a first mixed metal oxide containing titanium and tantalum on a substrate made of titanium or a titanium alloy by arc ion plating, a step of disposing a second intermediate layer made of a tantalum oxide and having a tantalum content of 1.2 to 2.5 g/m$^2$ by coating the first intermediate layer with a coating solution containing tantalum and then performing a heat treatment, and a step of disposing a catalyst layer made of a second mixed metal oxide containing iridium and tantalum by coating the second intermediate layer with a catalyst precursor solution containing iridium and tantalum, and then performing a heat treatment. The method for producing an electrode for oxygen evolution of the present invention is described in detail below.

The first intermediate layer made of the first mixed metal oxide is disposed on the substrate by arc ion plating (AIP). The substrate may be subjected to surface treatments such as blasting or etching, as necessary. By providing the first intermediate layer using the AIP method, as described above, it is possible to form the first intermediate layer having a relatively dense structure with a small proportion of voids formed inside.

When forming the second intermediate layer on the first intermediate layer, the surface of the first intermediate layer is first coated with a coating solution containing tantalum or a tantalum salt, but not containing iridium, to form a coated layer. Then, by performing baking under appropriate temperature conditions, the second intermediate layer made of a tantalum oxide can be provided. A thickness of the second intermediate layer to be formed and a content of the metal element (Ta) can be controlled by repeating the coating with the coating solution and the baking. A baking temperature is usually 400 to 600 °C, and preferably 450 to 550 °C. The coating solution does not contain titanium, and contains substantially only tantalum as a metal useful for the electrode for oxygen evolution.

When disposing the catalyst layer on the second intermediate layer, the surface of the second intermediate layer is first coated with a coating solution containing iridium, tantalum, salts of these metals, and the like in a desired ratio to form a coated layer. Then, by performing baking under appropriate temperature conditions, a catalyst layer made of the second mixed metal oxide can be provided. A thickness of the catalyst layer to be formed and a content of the metal element can be controlled by repeating the coating with the coating solution and the baking. A baking temperature is usually 400 to 600 °C, and preferably 450 to 550 °C.

By forming the catalyst layer on the second intermediate layer made of a tantalum oxide in this manner, the segregation of iridium toward the substrate in the catalyst layer is prevented and the segregation of tantalum toward the surface of the electrode is also prevented as described above. This is thought to be because the second intermediate layer does not contain iridium immediately after formation, even if a catalyst layer containing iridium is formed on the second intermediate layer, the distribution of iridium toward the substrate within the catalyst layer is prevented.

The method for producing an electrode for oxygen evolution according to the present embodiment preferably further includes a step of disposing a coating layer containing platinum on the catalyst layer by coating the catalyst layer with a coating solution containing platinum, and then performing a heat treatment. When disposing the coating layer on the catalyst layer, the surface of the catalyst layer is coated with a coating solution containing platinum, a platinum salt, or the like, similar to the formation of the catalyst layer described above. Then, by performing baking under appropriate temperature conditions, the coating layer can be formed on the catalyst layer. A thickness of the coating layer to be formed and a content of the metal element (Pt) can be controlled by repeating the coating with the coating solution and the baking. A baking temperature is usually 400 to 600 °C, and preferably 450 to 550 °C.

Examples

Hereinafter, the present invention will be specifically described based on Examples, but the present invention is not limited to these Examples. A "part" and "%" in Examples and Comparative Examples are based on mass unless otherwise specified.

<Pretreatment of Substrate and Formation of First Intermediate Layer>

A titanium plate (JIS-I) was prepared. A surface of the titanium plate was subjected to a dry blast with iron grit (G120 size), followed by annealing at 590 °C for 60 minutes. The obtained plate was etched using 20% hydrochloric acid at a boiling temperature for 20 minutes, followed by washing to obtain a substrate. The obtained substrate was set in an arc ion plating apparatus using a Ti-Ta alloy target as a vapor source, and the surface of the substrate was coated with a base layer (first intermediate layer) containing titanium and tantalum. Coating conditions are shown in Table 1.

Table 1

| Target (vapor source) | Alloy disk of Ti:Ta = 40:60 (mass ratio) (backside cooled with water) |
| --- | --- |
| Ultimate vacuum pressure ($\times$ 10$^{-2}$ Pa) | $\leq$ 1.5 |
| Substrate temperature (°C) | $\leq$ 500 |

(continued)

| Target (vapor source) | Alloy disk of Ti:Ta = 40:60 (mass ratio) (backside cooled with water) |
|---|---|
| Coating pressure ($\times$ 10$^{-1}$ Pa) | 3.0 to 4.0 |
| Vapor source input power | 20 to 30 V, 140 to 160 A |
| Coating time (min) | 15 to 20 |
| Coating thickness (in terms of increased mass; $\mu$m) | 2 |

<Production of Electrode for Oxygen Evolution>

(Comparative Example 1)

The substrate on which the first intermediate layer was formed was placed in an air-circulating electric furnace and was subjected to heat treatment at 530 °C for 180 minutes. A coating solution for a catalyst layer (65% Ir-35% Ta) was prepared by dissolving iridium tetrachloride (IrCl$_4$) and tantalum pentachloride (TaCl$_5$) in 10% hydrochloric acid. The first intermediate layer was coated with the prepared coating solution for a catalyst layer, followed by drying at 60 °C for 10 minutes. The dried product was placed in an air-circulating electric furnace and subjected to a pyrolysis treatment for heating at 520 °C for 10 minutes, followed by cooling in air. A catalyst layer was formed by repeating a cycle from the coating of the coating solution to cooling until a desired iridium content was achieved, and an electrode for oxygen evolution having a layer configuration shown in FIG. 3 was obtained.

(Examples 1 to 6 and Comparative Examples 2 to 5)

The substrate on which the first intermediate layer was formed was placed in an air-circulating electric furnace and was subjected to heat treatment at 530 °C for 180 minutes. Next, the first intermediate layer was coated with a coating solution for a second intermediate layer, which was prepared by dissolving tantalum pentachloride (TaCl$_5$) in 10% hydrochloric acid, followed by drying at 60 °C for 10 minutes. The dried product was placed in an air-circulating electric furnace and subjected to a pyrolysis treatment for heating at 520 °C for 10 minutes, followed by cooling in air. The second intermediate layer was formed by repeating a cycle from the coating with the coating solution to cooling until a desired tantalum content was achieved. Specifically, the tantalum contents of the second intermediate layer in Examples 1 to 6 were 1.2 g/m$^2$, 1.5 g/m$^2$, 1.8 g/m$^2$, 2.0 g/m$^2$, 2.2 g/m$^2$, and 2.3 g/m$^2$, respectively, and the tantalum contents of the second intermediate layer in Comparative Examples 2 to 5 were 1.0 g/m$^2$, 2.6 g/m$^2$, 2.7 g/m$^2$, and 3.0 g/m$^2$, respectively (all target values).
The second intermediate layer was coated with the above coating solution for a catalyst layer, followed by drying at 60 °C for 10 minutes. The dried product was placed in an air-circulating electric furnace and subjected to a pyrolysis treatment for heating at 520 °C for 10 minutes, followed by cooling in air. A catalyst layer was formed by repeating a cycle from the coating with the coating solution to cooling until the desired iridium content was achieved, and an electrode for oxygen evolution having a layer configuration shown in FIG. 1 was obtained.

(Example 7 and Comparative Examples 6 and 7)

The substrate on which the first intermediate layer was formed was placed in an air-circulating electric furnace and was subjected to heat treatment at 530 °C for 180 minutes. Next, the first intermediate layer was coated with the above coating solution for a second intermediate layer, followed by drying at 60 °C for 10 minutes. The dried product was placed in an air-circulating electric furnace and subjected to a pyrolysis treatment for heating at 520 °C for 10 minutes, followed by cooling in air. The second intermediate layer was formed by repeating a cycle from the coating with the coating solution to cooling until a desired tantalum content was achieved. Specifically, the tantalum contents of the second intermediate layer in Comparative Example 6, Example 7, and Comparative Example 7 were 1.0 g/m$^2$, 2.0 g/m$^2$, and 3.0 g/m$^2$, respectively (all target values).
The second intermediate layer was coated with the above coating solution for a catalyst layer, followed by drying at 60 °C for 10 minutes. The dried product was placed in an air-circulating electric furnace and subjected to a pyrolysis treatment for heating at 520 °C for 10 minutes, followed by cooling in air. The catalyst layer was formed by repeating a cycle from the coating with the coating solution to cooling until the desired iridium content was achieved.
A coating solution for a coating layer was prepared by dissolving dinitrodiammine platinum (Pt(NH$_3$)$_2$(NO$_2$)$_2$) in a 16 to 40% aqueous nitric acid solution. The catalyst layer was coated with the prepared coating solution, followed by drying at 60 °C for 10 minutes. The dried product was placed in an air-circulating electric furnace and subjected to a pyrolysis treatment for heating at 520 °C for 10 minutes, followed by cooling in air. A coating layer was formed by repeating a cycle from the coating with the coating solution to cooling until a desired platinum content was achieved, and an electrode for oxygen evolution having a layer configuration shown in FIG. 2 was obtained. The platinum content of the coating layer was 1.1 g/m$^2$ in any of Example 7 and Comparative Examples 6 and 7 (all target values).

(Reference Examples 1 to 3)

The substrate on which the first intermediate layer was formed was placed in an air-circulating electric furnace and was subjected to heat treatment at 530 °C for 180 minutes. The first intermediate layer was coated with the above coating solution for a catalyst layer, followed by drying at 60 °C for 10 minutes. The dried product was placed in an air-circulating electric furnace and subjected to a pyrolysis treatment for heating at 520 °C for 10 minutes, followed by cooling in air. The catalyst layer was formed by repeating a cycle from the coating with the coating solution to cooling until the desired iridium content was achieved.

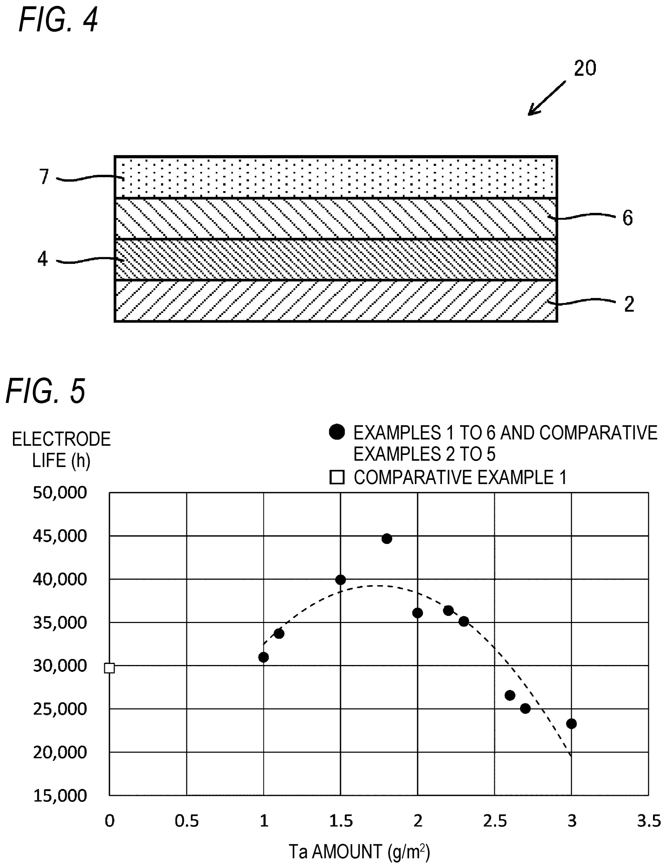

The catalyst layer was coated with the above coating solution for a coating layer, followed by drying at 60 °C for 10 minutes. The dried product was placed in an air-circulating electric furnace and subjected to a pyrolysis treatment for heating at 520 °C for 10 minutes, followed by cooling in air. A coating layer was formed by repeating a cycle from the coating with the coating solution to cooling until the desired platinum content was achieved, and an electrode for oxygen evolution having a layer configuration shown in FIG. 4 was obtained. Specifically, the platinum contents in Reference Examples 1, 2, and 3 were 1.1 g/m$^2$, 2.3 g/m$^2$, and 2.9 g/m$^2$, respectively (all target values).

Details of the electrodes for oxygen evolution obtained in Experimental Examples 1 to 7, Comparative Examples 1 to 7, and Reference Examples 1 to 3 are summarized in Table 2.

Table 2

| | Layer configuration | Ta amount (g/m$^2$) of second intermediate layer | Initial Ir amount (g/m$^2$) of catalyst layer | Pt amount (g/m$^2$) of coating layer |
|---|---|---|---|---|
| Comparative Example 1 | FIG. 3 | - | 7.1 | - |
| Comparative Example 2 | FIG. 1 | 1.0 | 6.4 | - |
| Example 1 | FIG. 1 | 1.2 | 5.4 | - |
| Example 2 | FIG. 1 | 1.5 | 5.5 | - |
| Example 3 | FIG. 1 | 1.8 | 5.5 | - |
| Example 4 | FIG. 1 | 2.0 | 4.9 | - |
| Example 5 | FIG. 1 | 2.2 | 5.3 | - |
| Example 6 | FIG. 1 | 2.3 | 5.3 | - |
| Comparative Example 3 | FIG. 1 | 2.6 | 5.4 | - |
| Comparative Example 4 | FIG. 1 | 2.7 | 5.2 | - |
| Comparative Example 5 | FIG. 1 | 3.0 | 3.8 | - |
| Comparative Example 6 | FIG. 2 | 1.0 | 6.4 | 1.1 |
| Example 7 | FIG. 2 | 2.0 | 4.9 | 1.1 |
| Comparative Example 7 | FIG. 2 | 3.0 | 3.8 | 1.1 |
| Reference Example 1 | FIG. 4 | - | 6.6 | 1.1 |
| Reference Example 2 | FIG. 4 | - | 6.3 | 2.3 |
| Reference Example 3 | FIG. 4 | - | 5.9 | 2.9 |

<Evaluation 1>

Each of cross sections of the electrodes for oxygen evolution obtained in Comparative Examples 1 to 5 and Examples 1 to 6 was analyzed using an electron probe microanalyzer (EPMA) to measure the distribution of iridium and tantalum in the formed catalyst layer. As a result, it was confirmed that in the catalyst layer of the electrode for oxygen evolution obtained in Comparative Example 1 as a conventional example, iridium segregated toward the substrate, and tantalum segregated toward the surface of the electrode. In this regard, in each of the catalyst layers of the electrodes for oxygen evolution obtained in Comparative Examples 2 to 5 and Experimental Examples 1 to 6 in which the second intermediate layer was disposed, it was confirmed that the segregation of iridium and tantalum was prevented, and the segregation of iridium toward the substrate was particularly prevented.

<Evaluation 2>

Electrolysis was performed under the following test conditions using the electrodes for oxygen evolution obtained in Comparative Examples 1 to 5 and Examples 1 to 6 as anodes. An iridium (Ir) amount in the electrode (catalyst layer) before and during the test was measured, and an initial Ir consumed amount during 0 to 1,000 hours after the start of the test was calculated, and an Ir consumption rate during 1,000 to 4,000 hours after the start of the test was calculated. The initial Ir consumed amount was calculated individually because the consumption rate up to about 1,000 hours after the start of the test differed from the consumption rate thereafter.

Furthermore, the obtained data was used to calculate a predicted value of an electrode life (0 hours to electrode degradation) (h) for each of the anodes using the following formula.

$$\text{Electrode life (0 hours to electrode degradation) (h)}$$
$$= \text{(initial Ir amount - remaining Ir amount - initial Ir consumed amount)/Ir}$$
$$\text{consumption rate} + 1,000$$

Here, for comparison purposes, the "initial Ir amount" for each of the anodes was standardized to 7 $g/m^2$.

Furthermore, regarding the "initial Ir consumed amount", since an outermost layer in each of Comparative Examples 1 to 5 and Examples 1 to 6 was a catalyst layer containing iridium and tantalum, an average initial Ir consumed amount (0.71 $g/m^2$) of each of the anodes was used for comparison. In each of Comparative Examples 6 and 7 and Example 7 in which the outermost layer was the coating layer (described below), the initial Ir consumed amount was reduced by the coating layer as described below, and therefore the measured initial Ir consumed amount was used as was.

The "remaining Ir amount" is a threshold for the remaining iridium amount at the time of electrode degradation (also referred to as a degradation determination value). As described above, the threshold for the remaining Ir amount of Examples 1 to 6 and Comparative Examples 2 to 5 each having the second intermediate layer can be set lower than the threshold in Comparative Example 1, which does not have the second intermediate layer. The threshold for the electrode of Comparative Example 1 was assumed to be 20% of the initial Ir amount (since the initial Ir amount was 7 $g/m^2$, the remaining Ir amount was 1.4 $g/m^2$) in consideration of field data, and the threshold for each of the electrodes of Examples 1 to 6 and Comparative Examples 2 to 5 was assumed to be 10% of the initial Ir amount (since the initial Ir amount was 7 $g/m^2$, the remaining Ir amount was 0.7 $g/m^2$), thereby calculating the predicted value of the electrode life (0 hours to electrode degradation) (h).

The tens digit of each of the calculated predicted values was rounded. The calculation results of the predicted values are shown in Table 3. FIG. 5 shows a graph plotting the predicted value of the electrode life (0 hours to electrode degradation) (h) with respect to a Ta amount ($g/m^2$) of the second intermediate layer.

As shown in Table 3, among Examples 1 to 6 and Comparative Examples 2 to 5 each including the second intermediate layer 5, the predicted value of electrode life for each of Examples 1 to 6 in which the tantalum contents of the second intermediate layers were 1.2 $g/m^2$, 1.5 $g/m^2$, 1.8 $g/m^2$, 2.0 $g/m^2$, 2.2 $g/m^2$, and 2.3 $g/m^2$, respectively, clearly exceeded the predicted value of electrode life of Comparative Example 1 as the conventional example. Note that, as shown by an approximate curve in FIG. 5 based on the predicted values of electrode life of Examples 1 to 6 and Comparative Examples 2 to 5, the predicted value of electrode life begins to decrease when the tantalum content exceeds approximately 1.8 $g/m^2$, but it can be said that up to 2.5 $g/m^2$, the predicted value of electrode life clearly exceeds the predicted value for Comparative Example 1. Therefore, it was confirmed that electrodes for oxygen evolution in which the tantalum contents were 1.2 to 2.5 $g/m^2$ in the second intermediate layers 5 could be used for electrolysis for a longer period of time than the conventional example.

[Test Conditions]

  ·Electrolytic solution: 150 g/L aqueous sulfuric acid ($H_2SO_4$) solution
  ·Electrolysis temperature: 60 °C

·Current density applied to anode: 10 kA/m$^2$

<Evaluation 3>

Electrolysis was performed under the following test conditions using the electrodes for oxygen evolution obtained in Comparative Examples 1, 6, and 7 and Example 7 as anodes. The iridium (Ir) amount in the electrode (catalyst layer) before and during the test was measured, and the predicted value of the electrode life (0 hours to electrode degradation) (h) was calculated using the same method as in Evaluation (2) described above. The tens digit of each of the calculated predicted values was rounded. The calculation results of the predicted values are shown in Table 3. As shown in Table 3, among Example 7 and Comparative Examples 6 and 7 each further including the coating layer 7, the predicted values of electrode life of Example 6 and Comparative Example 7 in which the tantalum contents of the second intermediate layers were 2.0 g/m$^2$ and 3.0 g/m$^2$, respectively, exceeded the predicted values of electrode life of Example 4 and Comparative Example 5 in which the tantalum contents were the same in the second intermediate layers but the coating layers 7 were not disposed. Note that the predicted values of electrode life of Comparative Example 6, Example 6, and Comparative Example 7 increased, and then decreased as the tantalum content increased. Therefore, it can be inferred that the electrodes for oxygen evolution further including the coating layer 7 and the electrodes having the tantalum content of the second intermediate layer 5 of 1.2 to 2.5 g/m$^2$ can be used for electrolysis for a longer period of time than that of the electrodes without a coating layer.

[Test Conditions]

·Electrolytic solution: 150 g/L aqueous sulfuric acid (H$_2$SO$_4$) solution

·Electrolysis temperature: 60 °C

·Current density applied to anode: 10 kA/m$^2$

Table 3

| | Comparative Example 1 | Comparative Example 2 | Example 1 | Example 2 | Example 3 | Example 4 | Example 5 |
|---|---|---|---|---|---|---|---|
| Ta amount (g/m$^2$) of second intermediate layer | - | 1.0 | 1.2 | 1.5 | 1.8 | 2.0 | 2.2 |
| Pt amount (g/m$^2$) of coating layer | - | - | - | - | - | - | - |
| Initial Ir amount (g/m$^2$) | 7.10 | 6.40 | 5.40 | 5.50 | 5.50 | 4.90 | 5.30 |
| Initial Ir consumed amount (0 to 1,000 hours) (g/m$^2$) | 0.85 | 0.73 | 0.63 | 0.91 | 0.87 | 0.62 | 0.63 |
| Ir consumption rate (1,000 to 4,000 hours) (mg/(m$^2$·h)) | 0.17 | 0.19 | 0.17 | 0.14 | 0.12 | 0.16 | 0.16 |
| Predicted value of electrode life (h) | 30,500 | 31,000 | 33,900 | 40,900 | 47,500 | 35,500 | 35,900 |
| | Example 6 | Comparative Example 3 | Comparative Example 4 | Comparative Example 5 | Comparative Example 6 | Example 6 | Comparative Example 7 |
| Ta amount (g/m$^2$) of second intermediate layer | 2.3 | 2.6 | 2.7 | 3.0 | 1.0 | 2.0 | 3.0 |
| Pt amount (g/m$^2$) of coating layer | | - | - | - | 1.1 | 1.1 | 1.1 |
| Initial Ir amount (g/m$^2$) | 5.30 | 5.40 | 5.20 | 3.80 | 6.40 | 4.90 | 3.80 |
| Initial Ir consumed amount (0 to 1,000 hours) (g/m$^2$) | 0.73 | 0.80 | 0.54 | 0.55 | 0.38 | 0.40 | 0.41 |
| Ir consumption rate (1,000 to 4,000 hours) (mg/(m$^2$·h)) | 0.16 | 0.22 | 0.24 | 0.26 | 0.22 | 0.16 | 0.22 |
| Predicted value of electrode life (h) | 35,900 | 26,400 | 24,300 | 22,700 | 28,200 | 38,100 | 28,100 |

**EP 4 711 505 A1**

<Evaluation 4>

Electrolysis was performed under the following test conditions using the electrodes for oxygen evolution obtained in Comparative Example 1 and Reference Examples 1 to 3 as anodes. The iridium (Ir) amount in the catalyst layer before and during the test was measured, and an initial reduction amount for each of Experimental Examples was calculated. Specifically, reduction amounts were calculated 500 hours and 1,000 hours after the start of the test, and the larger value, taking measurement error into consideration, was used as the initial reduction amount. The results are shown in Table 4. FIG. 6 shows a graph plotting the initial Ir reduction amount ($g/m^2$) with respect to the Pt amount ($g/m^2$) of the coating layer. As shown in Table 4, initial iridium reduction amounts of all of Reference Examples 1 to 3 each including the coating layer 7 were lower than an initial iridium reduction amount of Comparative Example 1 as the conventional example. As shown in FIG. 6, when the platinum content in the coating layer 7 is less than approximately 0.5 $g/m^2$, the initial iridium reduction amount remains large, and the effect of providing the coating layer 7 tends to be insufficient. On the other hand, when an initial platinum content exceeds approximately 3.0 $g/m^2$, an increase in the initial iridium reduction amount becomes gradual, and the effect of providing the coating layer 7 reaches a plateau. Therefore, when the platinum content in the coating layer 7 is 0.5 to 3.0 $g/m^2$, the initial iridium reduction amount can be more effectively reduced. The effect of the coating layer 7 is considered to be similarly exerted in an electrode in which the catalyst layer 6 is disposed on the second intermediate layer 5. Therefore, it could be confirmed that regarding the electrode for oxygen evolution further including the coating layer 7, in the electrode having the platinum content in the coating layer 7 of 0.5 to 3.0 $g/m^2$, a greater effect from the coating layer 7 than that of electrodes with different platinum contents could be obtained.

Note that in Reference Examples 1 to 3, the effect of reducing the initial iridium reduction amount in the catalyst layer 6 was confirmed when the coating layer 7 was provided and the second intermediate layer 5 was not provided between the first intermediate layer 4 and the catalyst layer 6. Even when the second intermediate layer 5 was provided between the first intermediate layer 4 and the catalyst layer 6, the effect of reducing the initial iridium reduction amount in the catalyst layer 6 was obtained by providing the coating layer 7 on the catalyst layer 6, similar to Reference Examples 1 to 3.

[Test Conditions]

·Electrolytic solution: 150 g/L aqueous sulfuric acid ($H_2SO_4$) solution
·Electrolysis temperature: 60 °C
·Current density applied to anode: 10 kA/$m^2$

Table 4

| | Comparative Example 1 | Reference Example 1 | Reference Example 2 | Reference Example 3 |
|---|---|---|---|---|
| Initial Ir amount ($g/m^2$) of catalyst layer | 7.10 | 6.60 | 6.30 | 5.90 |
| Initial Pt amount ($g/m^2$) of coating layer | - | 1.10 | 2.30 | 2.90 |
| Initial Ir reduction amount ($g/m^2$) | 0.85 | 0.35 | 0.14 | 0.15 |

INDUSTRIAL APPLICABILITY

The electrode for oxygen evolution of the present invention is useful as an anode used in an electrowinning process in which a current density to be applied is 10 kA/$m^2$ or less, such as in the production of electrolytic copper foil.

REFERENCE SIGNS LIST

10, 20, 30, 40: electrode for oxygen evolution
2: substrate
4: first intermediate layer
5: second intermediate layer

6: catalyst layer
7: coating layer

**Claims**

1. An electrode for oxygen evolution comprising:

   a substrate made of titanium or a titanium alloy;
   a first intermediate layer disposed on the substrate and made of a first mixed metal oxide containing titanium and tantalum;
   a catalyst layer disposed above the first intermediate layer and made of a second mixed metal oxide containing iridium and tantalum; and
   a second intermediate layer disposed between the first intermediate layer and the catalyst layer, made of a tantalum oxide, and having a tantalum content of 1.2 to 2.5 $g/m^2$.

2. The electrode for oxygen evolution according to claim 1, further comprising:
   a coating layer disposed on the catalyst layer and containing platinum.

3. The electrode for oxygen evolution according to claim 2, wherein
   a platinum content in the coating layer is 0.5 to 3.0 $g/m^2$.

4. The electrode for oxygen evolution according to any one of claims 1 to 3, wherein
   the first intermediate layer is a layer formed by an arc ion plating method.

5. A method for producing an electrode for oxygen evolution, the method comprising:

   disposing a first intermediate layer made of a first mixed metal oxide containing titanium and tantalum on a substrate made of titanium or a titanium alloy by arc ion plating;
   disposing a second intermediate layer made of a tantalum oxide and having a tantalum content of 1.2 to 2.5 $g/m^2$ by coating the first intermediate layer with a coating solution containing tantalum but not containing iridium, and then performing a heat treatment; and
   disposing a catalyst layer made of a second mixed metal oxide containing iridium and tantalum by coating the second intermediate layer with a catalyst precursor solution containing iridium and tantalum, and then performing a heat treatment.

6. The method for producing an electrode for oxygen evolution according to claim 5, the method further comprising:
   disposing a coating layer containing platinum on the catalyst layer by coating the catalyst layer with a coating solution containing platinum, and then performing a heat treatment.

*FIG. 1*

*FIG. 2*

*FIG. 3*

*FIG. 4*

*FIG. 5*

*FIG. 6*

## INTERNATIONAL SEARCH REPORT

| International application No. |
|---|
| **PCT/JP2024/035789** |

| A. | CLASSIFICATION OF SUBJECT MATTER |
|---|---|

*C25B 11/067*(2021.01)i; *C25B 11/04*(2021.01)i; *C25B 11/052*(2021.01)i; *C25B 11/063*(2021.01)i; *C25B 11/069*(2021.01)i; *C25B 11/081*(2021.01)i; *C25C 7/02*(2006.01)i

FI: C25B11/067; C25B11/04; C25B11/052; C25B11/063; C25B11/069; C25B11/081; C25C7/02 306

According to International Patent Classification (IPC) or to both national classification and IPC

| B. | FIELDS SEARCHED |
|---|---|

Minimum documentation searched (classification system followed by classification symbols)

C25B11/067; C25B11/04; C25B11/052; C25B11/063; C25B11/069; C25B11/081; C25C7/02

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 2009-263771 A (PERMELEC ELECTRODE LTD.) 12 November 2009 (2009-11-12)<br>entire text | 1-6 |
| A | JP 2014-530292 A (PERMELEC ELECTRODE LTD.) 17 November 2014 (2014-11-17)<br>entire text | 1-6 |
| A | CN 108554756 A (NINGXIA TIANYUAN MANGANESE LIMITED COMPANY) 21 September 2018 (2018-09-21)<br>entire text | 1-6 |
| A | JP 5-171483 A (DAISO CO., LTD.) 09 July 1993 (1993-07-09)<br>entire text | 1-6 |
| A | JP 9-25591 A (ISHIFUKU METAL IND CO., LTD.) 28 January 1997 (1997-01-28)<br>entire text | 1-6 |

☐ Further documents are listed in the continuation of Box C.    ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **04 December 2024** | **17 December 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
**Information on patent family members**

International application No.

**PCT/JP2024/035789**

| Patent document cited in search report | | | Publication date (day/month/year) | Patent family member(s) | | | Publication date (day/month/year) |
|---|---|---|---|---|---|---|---|
| JP | 2009-263771 | A | 12 November 2009 | US | 2009/0242417 | A1 | |
| | | | | entire text | | | |
| | | | | EP | 2107137 | A1 | |
| | | | | CN | 101550557 | A | |
| | | | | TW | 200942646 | A | |
| | | | | MY | 143925 | A | |
| | | | | HK | 1132306 | A | |
| JP | 2014-530292 | A | 17 November 2014 | US | 2015/0075978 | A1 | |
| | | | | entire text | | | |
| | | | | WO | 2013/099780 | A2 | |
| | | | | TW | 201339372 | A | |
| | | | | AU | 2012361801 | A | |
| | | | | CA | 2859939 | A | |
| | | | | CN | 104024481 | A | |
| | | | | KR | 10-2014-0101425 | A | |
| CN | 108554756 | A | 21 September 2018 | (Family: none) | | | |
| JP | 5-171483 | A | 09 July 1993 | (Family: none) | | | |
| JP | 9-25591 | A | 28 January 1997 | (Family: none) | | | |

Form PCT/ISA/210 (patent family annex) (July 2022)

**REFERENCES CITED IN THE DESCRIPTION**

**Patent documents cited in the description**

- JP H0559580 A

- JP 2009263770 A

**Non-patent literature cited in the description**

- *Journal of Applied Electrochemistry*, 1991, vol. 21, 335-345